# EUROPEAN PATENT SPECIFICATION

(11) **EP 0 259 490 B1**
(45) Date of publication and mention of the grant of the patent: **13.07.1994**
(21) Application number: 86902001.6
(22) Date of filing: 05.03.1986
(51) Int. Cl.: H01L 21/60, H01L 21/28

(54) **A METHOD OF PRODUCING A SEMICONDUCTOR DEVICE**
HERSTELLUNG EINER HALBLEITERANORDNUNG
PROCEDE DE PRODUCTION D'UN DISPOSITIF SEMI-CONDUCTEUR

(43) Date of publication of application: 16.03.1988
(73) Proprietor: SUMITOMO ELECTRIC INDUSTRIES LIMITED, Osaka-shi, Osaka 541 (JP)
(72) Inventor: EBATA, Toshiki Osaka Works of Sum., Konohana-ku Osaka-shi Osaka 554 (JP)
(74) Representative: Lehn, Werner, Dipl.-Ing.
(86) International application number: PCT/JP86/00113
(87) International publication number: WO 87/05441

(56) References cited:
- EP-A- 0 085 916
- JP-A- 5 056 886
- JP-A-49 132 987
- JP-A-52 154 351
- JP-B- 501 514
- JP-B- 5 841 775
- US-A- 4 523 372

## Description

### TECHNICAL FIELD

The present invention relates to a method of manufacturing a semiconductor device and more particularly, to method of manufacturing a semiconductor device of flat configuration suitable for multilayer interconnection and a in which, by employing a lift-off method in an integrated circuit, an electrode and a first level interconnection are formed at a high yield.

### BACKGROUND ART

In the case where a field effect transistor (FET) or an integrated circuit is produced on a substrate made of compound semiconductor, a lift-off method is generally employed for forming various electrodes or a first level interconnection on a surface of the substrate. It is because if a wet etching method used generally in the manufacture of a large scale integrated circuit (LSI) made of Si, i.e., a method in which metal of the electrodes or metal of the first level interconnection is etched by using acid or basic agent is applied to the manufacture of the substrate made of compound semiconductor, such a problem arises that chemical reaction between the agent and the substrate takes place. Furthermore, in view of the fact that micro processing similar to that for the manufacture of a very large scale integrated circuit (VLSI) made of Si is required for the manufacture of the substrate made of compound semiconductor, the wet etching method is improper for the manufacture of the substrate made of compound semiconductor. In order to microminiaturize the substrate made of compound semiconductor, a so-called plasma etching method using, in place of the agent, ions generated in gas plasma or a reactive ion etching method is proposed. However, these two known methods have the same problem as the wet etching method because the substrate made of compound semiconductor has low selectivity for materials to be etched. Furthermore, the two known methods are inevitably disadvantageous in that the substrate made of compound semiconductor may be damaged through plasmatic irradiation or ion bombardment thereto.

### DISCLOSURE OF THE INVENTION

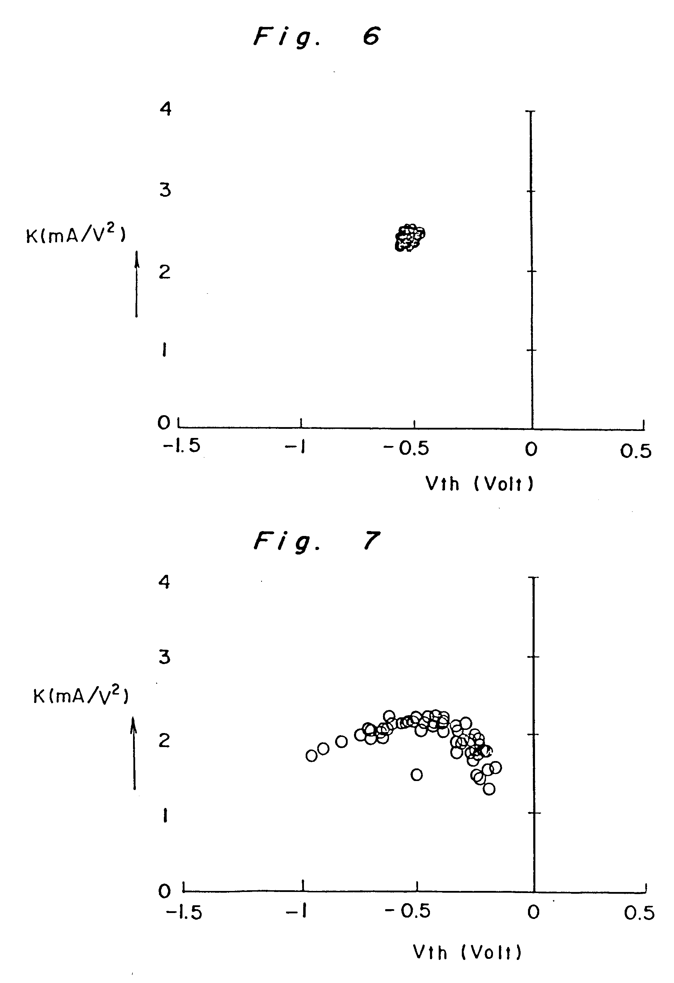

In order to reduce electric resistances of electrodes and wires in microminiaturization of an integrated circuit, the electrodes and the wires are required to be increased in thickness. At this time, if the lift-off method is employed for forming the electrodes and the wires, burrs 30, for example, are produced on a gate electrode 2 as shown in Figs. 3(A) and 3(B). If multilayer interconnection is performed without removing such burrs, such inconveniences are caused that since a layer insulation film is cracked at the burrs or concentration of electric field occurs between upper and lower wires, a shortcircuiting phenomenon takes place, thereby resulting in drop of yield of the integrated circuit. Meanwhile, in Fig. 3(A), reference numeral 21 represents a photoresist.

In order to remove the above-described burrs, a multilayer resist method shown in Figs. 4(A) - 4(D) schematically illustrating its manufacturing process is put to trial. The multilayer resist method aims to prevent production of the burrs by increasing the thickness of the resist for use in the lift-off and, at the same time, forming a cross section of the resist into an inverse trapezoidal shape. However, in the multilayer resist method, since the lowermost resist is generally subjected to reactive ion etching from a microminiature standpoint, damage to the surface of the semiconductor may take place. In addition, the multilayer resist method has such a disadvantage that its processes are large in number and complicated, thus resulting in not only poor controllability and reproducibility but low yield and productivity. Meanwhile, in Fig. 4, reference numerals 21 and 23 represent photoresists, reference numeral 22 represents an intermediate layer and reference numeral 2 represents the gate electrode.

In order to solve the above-described problems, there is, for example, an insulating film (spacer) lift-off method shown in Figs. 5(A) - 5(D) schematically illustrating its manufacturing processes. In the spacer lift-off method, the lower resist layer of the multilayer resist method is replaced by an insulating film 11 and such an advantage can be gained that the integrated circuit is formed, after the lift-off, into a flat configuration. However, since reactive ion etching is performed for processing the insulating film, such a problem as damage to the surface of the semiconductor substrate still arises. For example, when a field effect transistor (FET) is produced on a GaAs substrate in the spacer lift-off method by using a silicon nitride film as the insulating film, it was found that a threshold voltage (Vth) of the FET scatters widely.

US-A-4 523 372 discloses a device in which an electrode is formed on a substrate, followed by a two-layer insulating film. When the lower layer is etched to make an opening to the electrode, the electrode acts to protect the substrate. However, the lower layer inevitably overlaps the edges of the electrode.

An object of the present invention is to provide a method of manufacturing a semiconductor device, which at least partially eliminates the above-described disadvantages.

According to the present invention there is provided a method of manufacturing a semiconductor device, comprising the steps of:
forming a two-layer insulating film on a surface of a substrate made of compound semiconductor;
said two-layer film being constituted by a first or lower insulating film and a second or upper insulating film;
said lower and said upper insulating films, being, respectively, made of two kinds of insulating materials;
forming a predetermined photoresist pattern on said upper insulating film;
performing reactive ion etching of said upper insulating film through utilization of said photoresist pattern as a mask and subsequently, performing wet etching of said lowor insulating film through utilisation said photoresist pattern and said second insulating film as a mask so as to form an opening identical to said photoresist pattern, on said two-layer film constituted by said lower and upper insulating films;
subsequently depositing a metal for forming both an electrode and a first level interconnection; and
performing a lift-off operation using said photoresist pattern.

### BRIEF DESCRIPTION OF THE DRAWINGS

Fig. 1 is a sectional view explanatory of a structure of the present invention;
Figs. 2(A) - 2(G) are views indicative of a method of manufacturing a semiconductor device, according to one embodiment of the present invention;
Figs. 3(A) and 3(B) are views explanatory of formation of an electrode by the use of a prior art lift-off method;
Figs. 4(A) - 4(D) are views explanatory of a prior art multilayer resist method;
Figs. 5(A) - 5(D) are views explanatory of a prior art insulating film (spacer) lift-off method;
Fig. 6 is a graph indicative of distribution of threshold voltage, which is characteristic of a field effect transistor (FET) produced by the embodiment of the present invention on a wafer having a two-layer insulating film; and
Fig. 7 is a graph showing distribution characteristics of threshold voltage of a field effect transistor (FET) produced by the prior art insulating film (spacer) lift-off method.

### BEST MODE FOR WORKING THE INVENTION

Hereinbelow, an embodiment according to the present invention will be explained in detail by referring to the drawings.

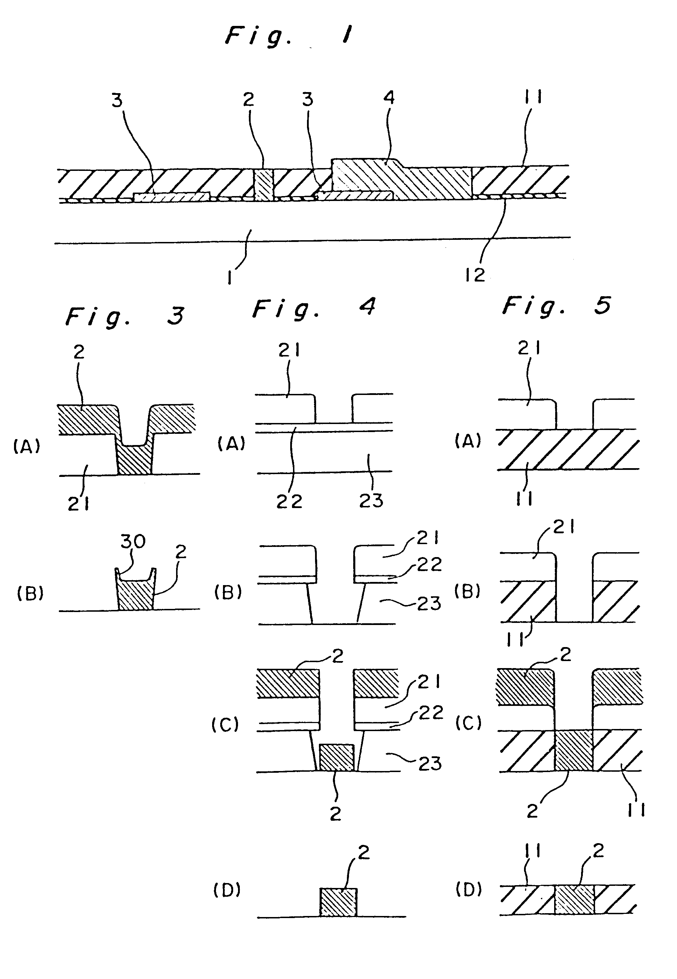

Fig. 1 is a sectional view explanatory of a structure of the present invention.

The present invention has such an essential feature that two kinds of insulating films 11 and 12, which are different from each other in chemical properties, are piled on a surface of a semiconductor substrate 1 and a gate electrode 2, an ohmic electrode 3 and a first level interconnection 4 are embedded in an opening formed on the two insulating films 11 and 12.

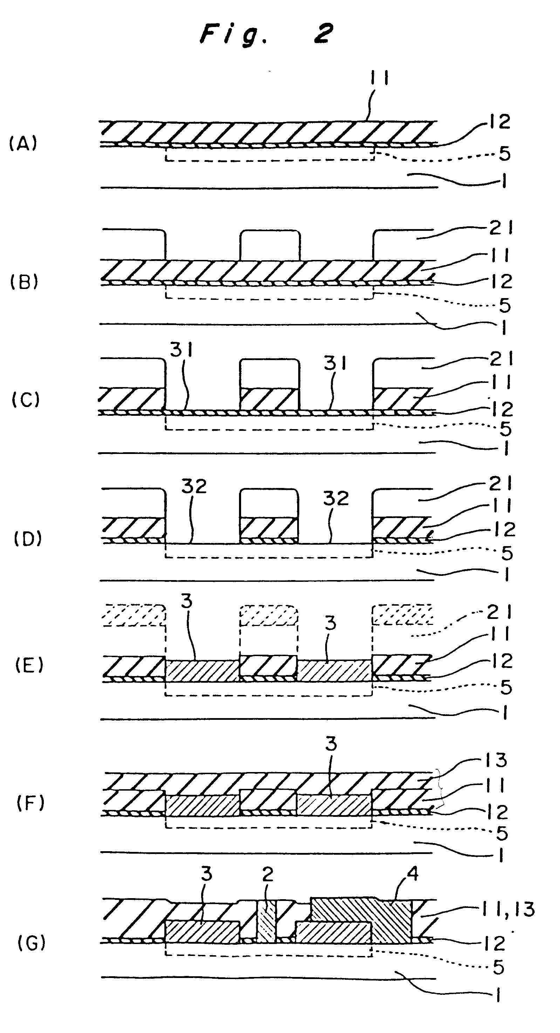

A method of manufacturing a semiconductor device, according to one embodiment of the present invention is shown in Figs. 2(A) - 2(G).

In this embodiment, a field effect transistor (FET) is produced on the semiconductor substrate, e.g., a GaAs substrate 1 by way of example.

Initially, the lower or first insulating film 12, e.g., a silicon dioxide (SiO₂) film 12 having a thickness of 100 nm (1000 Å) is formed, by using an ordinary chemical vapor deposition (CVD) method, on a surface of the GaAs substrate 1 provided with an electrically conductive layer 5. Then, the upper or second insulating film 11 made of an insulating material different from that of the SiO₂ film 12, e.g., a silicon nitride (Si-N) film 11 having a thickness of 350 nm (3500 Å) is formed on the SiO₂ film 12 by using a plasma CVD method (Fig. 2(A)).

A predetermined photoresist pattern 21 is formed on the two insulating films 11 and 12 (Fig. 2(B)).

The upper Si-N film 11 is subjected to reactive ion etching using, for example, plasma of carbon tetrafluoride (CF₄) gas at a gas pressure of 5x10⁻² Torr (6.6 Pa approx.) and at an electric power of 100 W for 2 min. through utilization of the photoresist pattern 21 as a mask such that an opening 31 identical to the photoresist pattern 21 is formed. At this time, since an etching speed of the lower SiO₂ film 12 is one-fifth of that of the upper Si-N film 11, the reactive ion etching is substantially blocked by the lower SiO₂ film 12 (Fig. 2(C)).

Thereafter, the lower SiO₂ film 12 is subjected to, for example, wet etching, e.g., etching for 30 sec. by using a buffer solution of hydrofluoric acid through utilization of the photoresist pattern 21 and the upper Si-N film 11 as a mask for the wet etching such that an opening 32 is formed (Fig. 2 (D)).

Immediately after the above step, an Au-Ge/Ni/Au alloy is deposited in the opening 32 to a film thickness of 400 nm (4000 Å) and then, a lift-off operation is performed such that an ohmic electrode 3 is formed (Fig. 2(E)).

Subsequently, after heat treatment at 450^{o}C, an insulating film made of a material identical to that of the upper Si-N film 11, i.e., a Si-N film 13 of 300 nm (3000 Å) in thickness is formed by using the plasma CVD method (Fig. 2(F)).

Finally, openings are formed on the two insulating film, e.g., the lower SiO₂ film 12 and the upper Si-N films 11, 13 by employing the same steps as described above and then, for example, a Ti/Au alloy is deposited in the openings to a film thickness of 700 nm (7000 Å). Subsequently, a lift-off operation is performed such that a gate electrode 2 and a first level interconnection 4 is formed in the openings (Fig. 2(G)).

Fig. 6 shows distribution of threshold voltage of the field effect transistor (FET) produced, by employing the method according to the present embodiment, on the wafer having the two-layer insulating film. For comparison, Fig. 7 shows a typical example of distribution of threshold voltage of the FET produced in the conventional insulating film (spacer) lift-off method (Fig. 5(A) to 5(D)) in which the lower insulating film is not provided. In Figs. 6 and 7, the axis of abscissa represents threshold voltage Vth (Volt) of the FET, while the axis of ordinate represents performance index K factor (mA/V²) indicating current driving capability of the FET. From comparison between Figs. 6 and 7, it is apparent that the surface of the semiconductor substrate is damaged by reactive ion etching, thereby resulting in aggravation of characteristics of the FET. Thus, effectiveness of the present invention will be understood.

The present invention has such an essential feature that when the upper and lower insulating films are subjected to reactive ion etching and wet etching respectively, the upper and lower insulating films have selectivity for reactive ion etching and wet etching, respectively. Since the object of the present invention can be accomplished if the semiconductor substrate is not damaged by etching of the lower insulating film, etching of the lower insulating film is not limited to wet etching of the present embodiment. Thus, it is needless to say that plasma etching, etc. can also be employed for etching the lower insulating film. In this connection, combination of materials of the two-layer insulating film is not restricted to that of the embodiment. Namely, arbitrary combinations of Si-N/Polyimide resin or Polyimide resin/SiO₂ can be made.

Furthermore, in the present embodiment, when the lower insulating film, i.e., the SiO₂ film is subjected to wet etching, side etching is minimized by forming the SiO₂ film into a small thickness of 100 nm (1000 Å) such that accuracy of micro processing is improved. However, the lower insulating film can, needless to say, be set at an arbitrary thickness in accordance with the required accuracy.

### EFFECT OF THE INVENTION

As is clear from the foregoing description, in accordance with the present invention, the electrodes and the first level interconnection are so formed as to be embedded in the two-layer insulating film such that the semiconductor device is formed into a flat configuration. Furthermore, since the upper insulating film having a large thickness is processed by reactive ion etching having high anisotropy, it becomes possible to perform high precision micro processing of the upper insulating film. In addition, since the reactive ion etching is blocked by the lower insulating film, the surface of the substrate made of compound semiconductor is protected from damage due to ion bombardment. Moreover, since the lower insulating film is subjected to wet etching, such an effect is achieved that metallic materials of the electrodes and the first level interconnection are deposited on the etched clean surface.

## Claims

1. A method of manufacturing a semiconductor device, comprising the steps of:
forming a two-layer insulating film (11,12) on a surface of a substrate (1) made of compound semiconductor;
said two-layer film being constituted by a first or lower insulating film (12) and a second or upper insulating film (11);
said lower and said upper insulating films being,respectively, made of two kinds of insulating materials;
forming a predetermined photoresist pattern (21) on said upper insulating film;
performing reactive ion etching of said upper insulating film (11) through utilization of said photoresist pattern as a mask and subsequently, performing wet etching of said lower insulating film through utilization of said photoresist pattern and said upper insulating film (11) as a mask so as to form an opening identical to said photoresist pattern, on said two-layer film constituted by said lower and said upper insulating films (11,12);
subsequently depositing a metal forming both an electrode (3) and a first level interconnection (4); and
performing a lift-off operation using said photoresist pattern (21).

2. A method of manufacturing a semiconductor device as claimed in Claim 1, wherein said lower and said upper insulating films constituting said two-layer insulating film are, respectively, made of silicon oxide and silicon nitride.

3. A method of manufacturing a semiconductor device as claimed in Claim 1, wherein said lower and said upper insulating films constituting said two-layer insulating film are, respectively, made of silicon oxide and Polyimide resin.

4. A method of manufacturing a semiconductor device as claimed in Claim 2 or Claim 3, wherein said silicon oxide of said lower insulating film of said two-layer insulating film has a thickness of not more than 200 nm (2000 Å).

## Patentansprüche

1. Verfahren zur Herstellung eines Halbleiterbauteils, umfassend die Schritte:
Ausbilden eines Zweischichtisolierfilms (11,12) auf einer Oberfläche eines aus Verbindungshalbleiter hergestellten Substrats (1);
wobei der Zweischichtfilm durch einen ersten oder unteren Isolierfilm (12) und einen zweiten oder oberen Isolierfilm (11) gebildet wird;
wobei der untere und der obere Isolierfilm jeweils aus zwei Arten von Isoliermaterialien hergestellt sind;
Ausbilden eines vorbestimmten Photoresistmusters (21) auf dem oberen Isolierfilm;
Durchführen von Reaktivionenätzen des oberen Isolierfilms (11) unter Verwendung des Photoresistmusters als Maske, und anschließend Durchführen von Naßätzen des unteren Isolierfilms unter Verwendung des Photoresistmusters und des oberen Isolierfilms (11) als Maske, um auf dem durch den unteren und oberen Isolierfilm (11,12) gebildeten Zweischichtfilm eine Öffnung zu bilden, die dem Photoresistmuster gleich ist;
anschließend Abscheiden eines Metalls, das sowohl eine Elektrode als auch eine Erstlagenverdrahtung bildet; und
Durchführen eines Abhebevorgangs unter Verwendung des Photoresistmusters (21).

2. Verfahren zur Herstellung eines Halbleiterbauteils nach Anspruch 1, dadurch gekennzeichnet, daß der den Zweischichtisolierfilm bildende untere und obere Isolierfilm aus Siliziumoxid bzw. Siliziumnitrid hergestellt sind.

3. Verfahren zur Herstellung eines Halbleiterbauteils nach Anspruch 1, dadurch gekennzeichnet, daß der den Zweischichtisolierfilm bildende untere und obere Isolierfilm aus Siliziumoxid bzw. Polyimidharz hergestellt sind.

4. Verfahren zur Herstellung eines Halbleiterbauteils nach Anspruch 2 oder Anspruch 3, dadurch gekennzeichnet, daß das Siliziumoxid des unteren Isolierfilms des Zweischichtisolierfilms eine Dicke von nicht mehr als 200 nm (2000 Å) aufweist.

## Revendications

1. Procédé de fabrication d'un dispositif à semiconducteur, comprenant les étapes de :
formation d'un film isolant bicouche (11, 12) sur une surface d'un substrat (1) réalisé en un semiconducteur composite ;
ledit film bicouche étant constitué par un premier film isolant ou film isolant inférieur (12) et par un second film isolant ou film isolant supérieur (11) ; lesdits films isolants inférieur et supérieur étant respectivement réalisés en deux types de matériaux isolants ;
formation d'un motif de photoréserve prédéterminé (21) sur ledit film isolant supérieur ;
réalisation d'une gravure ionique réactive dudit film isolant supérieur (11) par l'intermédiaire de l'utilisation dudit motif de photoréserve en tant que masque puis ensuite, réalisation d'une gravure par voie humide dudit film isolant inférieur par l'intermédiaire de l'utilisation dudit motif de photoréserve et dudit film isolant supérieur (11) en tant que masque de manière à former une ouverture identique audit motif de photoréserve, sur ledit film bicouche constitué par lesdits films isolants inférieur et supérieur (11, 12) ;
puis dépôt d'un métal formant à la fois une électrode (3) et une interconnexion de premier niveau (4) ; et
réalisation d'une opération d'enlèvement par gravure sous-jacente en utilisant ledit motif de photoréserve (21).

2. Procédé de fabrication d'un dispositif à semiconducteur selon la revendication 1, dans lequel lesdits films isolants inférieur et supérieur qui constituent ledit film isolant bicouche sont respectivement réalisés en oxyde de silicium et en nitrure de silicium.

3. Procédé de fabrication d'un dispositif à semiconducteur selon la revendication 1, dans lequel lesdits films isolants inférieur et supérieur qui constituent ledit film isolant bicouche sont respectivement réalisés en oxyde de silicium et en résine polyimide.

4. Procédé de fabrication d'un dispostif à semiconducteur selon la revendication 2 ou 3, dans lequel ledit oxyde de silicium dudit film isolant inférieur dudit film isolant bicouche présente une épaisseur non supérieure à 200 nm (2000 Å).
